# EUROPÄISCHE PATENTSCHRIFT

(11) **EP 0 250 391 B1**
(45) Veröffentlichungstag und Bekanntmachung des Hinweises auf die Patenterteilung: **20.01.1993**
(21) Anmeldenummer: 87890102.4
(22) Anmeldetag: 15.05.1987
(51) Int. Cl.: H01J 37/30, H01J 37/317

(54) **Anordnung zum Positionieren der Abbildung der Struktur einer Maske auf ein Substrat**
Arrangement for positioning a structure image of a mask on a substrate
Dispositif de positionnement d'une structure d'image d'un masque sur un substrat

(30) Priorität: 16.05.1986 AT 1314/86
(43) Veröffentlichungstag der Anmeldung: 23.12.1987
(73) Patentinhaber: IMS Ionen Mikrofabrikations Systeme Gesellschaft m.b.H., A-1020 Wien (AT); Österreichische Investitionskredit Aktiengesellschaft, 1013 Wien (AT)
(72) Erfinder: Löschner, Hans, Dr., A-1190 Wien (AT); Stengl,Gerhard, Dr., A-9500 Villach Kärnten (AT)
(74) Vertreter: Casati, Wilhelm, Dipl.-Ing.

(56) Entgegenhaltungen:
- SOLID STATE TECHNOLOGY, Band 29, Nr. 2, Februar 1986, Seiten 119-126, Port Washington, New York, US; G. STENGL et al.: "Ion projection lithography"

## Beschreibung

Die Erfindung betrifft eine Anordnung zum Positionieren der Abbildung der Struktur einer Maske auf ein Substrat, für die Ionenprojektionslithographie, bei dem die Maske und das Substrat an miteinander korrespondierenden Stellen mit Markierungen versehen, die Markierungen der Maske auf das Substrat abgebildet und durch Beeinflussung des Strahles, die Abbildungen der Markierungen der Maske auf dem Substrat in Koinzidenz mit den auf dem Substrat vorhandenen, jeweils korrespondierenden Markierungen gebracht werden, mittels einer Ionenprojektionseinrichtung, bei der im Strahlengang zwischen Maske und dem Substrat ein elektrostatischer Multipol, insbes. Oktopol, eine Einrichtung zur Erzeugung eines magnetischen Drehfeldes um die optische Achse und eine hinsichtlich derangelegten Spannung steuerbare Projektionslinse zur Änderung des Abbbildungsmaßstabes angeordnet sind, wobei die Projektionseinrichtung mit Detektoren für die von den Markierungen auf dem Substrat ausgehende Sekundärstrahlung in einer durch zwei teilbaren Anzahl versehen ist und die Markierungen auf dem Substrat von Zonen, z.B. Nuten mit V-Querschnitt, gebildet sind, deren Emissionsvermögen für Sekundär-Strahlung unterschiedlich von jenem des Substrates ist und von den Detektorpaaren jeweils zwei Paare zur Steuerung des Multipoles, ein Paar zur Steuerung der Einrichtung zur Erzeugung eines magnetischen Drehfeldes und ein weiteres Paar zur Steuerung der Projektionslinse entweder im Sinne einer Vergrößerung oder Verkleinerung der Abbildung vorgesehen sind.

Eine Anordnung der vorgenannten Art wurde aus Solid State Technology, Band 29, Nr. 2, Februar 86, Seiten 119 - 126, Port Washington, New York, US; G.Stengl et al.: "Ion Projection Lithography", bekannt. An die lagegenaue Abbildung der Struktur einer Maske, das sogenannte Alignment, werden nun besonders hohe Anforderungen gestellt, da zu berücksichtigen ist, daß die Lagegenauigkeit größenordnungsmäßig ca. 10 - 20 % der Kleinsten abzubildenden Linienbreite betragen muß. Geht man davon aus, daß mit Linienbreiten unter 0,5 µm gearbeitet werden soll, so muß die Genauigkeit des Alignment unter 0,05 bis 0,1 µm liegen. Hinzu kommt noch, daß die Ausrichtung möglichst rasch zu erfolgen hat, da die Zeit für die Ausrichtung in die Produktionszeit eingeht.

Dadurch, daß für die einzelnen Verstellungen selbständig arbeitende Detektorpaare vorgesehen sind, mittels welchen die Ausrichtung durch Beeinflussung des Strahles erfolgt, somit das Bild der Maske aufdem Substrat verschoben wird, kann - wie das vorgenannte Dokument erwähnt - eine mechanische Verschiebung des Trägertisches für das Substrat auf die grobe Ausrichtung (etwa 1 µm Genauigkeit) beschränkt werden und die endgültige Ausrichtung des Bildes der Maske auf das zugehörige Bild auf dem Substrat ohne Ausführung mechanischer Bewegungen und damit sehr rasch erfolgen, wobei auch die entsprechende Deckungsgenauigkeit zwischen der Abbildung der Markierungen der Maske und den entsprechenden Markierungen auf dem Substrat erreicht wird.

Dadurch, daß die Zeit, die für die Ausrichtung benötigt wird, sehr gering ist, ist es auch möglich, die Ausrichtung während der eigentlichen Belichtungszeit vorzunehmen, ohne daß dadurch, bedingt durch den Umstand, daß zu Beginn der Belichtung das Bild der Maske noch nicht die richtige Lage auf dem Substrat hatte, wesentliche Belichtungsfehler am Substrat entstehen.

Als Detektoren können handelsübliche Elemente eingesetzt werden, u.zw. in der Weise, daß Ionenvervielfacherkanäle, sogenannte Channeltrons, zur Erzeugung einer von der Anzahl der erfaßten Ionen abhängigen Steuerspannung verwendet werden.

Aufgabe der Erfindung ist es, eine Anordnung der eingangs erwähnten Art so weiterzubilden, daß eine Entkoppelung der einzelnen Alignmentbewegungen in einer solchen Weise erreicht wird, daß eine Bewegung in einem Sinne, z.B. eine Bewegung in X-Richtung, die bereits vorhandene Einstellung in einer anderen Richtung, z.B. in der Y-Richtung, nicht mehr beeinflußt, sodaß praktisch in jeder Verstellrichtung eine einmalige Justierung ausreichend ist und die in einer Richtung vorgenommene Justierung durch eine Justierung in einer anderen Richtung nicht mehr beeinflußt wird. Erreicht wird dies dadurch, daß bei einer Anordnung der eingangs erwähnten Art, die jedem Detektorpaar auf dem Substrat zugeordnete Markierung geradlinig ausgebildet ist, wobei zwei der Markierungen miteinander fluchtend auf dem Substrat angeordnet sind, eine dritte Markierung unter einem Winkel, bevorzugt unter einem rechten Winkel, zu den beiden miteinander fluchtenden Markierungen angeordnet ist und eine vierte Markierung parallel zur dritten, jedoch seitlich zu dieser versetzt auf dem Substrat angeordnet ist.

Für die Anpassung hinsichtlich des Maßstabes der Abbildung ist es von besonderem Vorteil, wenn in der Symmetrielinie zwischen den beiden fluchtend zueinander angeordneten Markierungen die unter einem Winkel zu diesen Markierungen liegende dritte Markierung angeordnet ist.

Als Zonen, deren Emissionsvermögen für Sekundärstrahlung unterschiedlich von jenem des Substrates ist, können die geradlinigen Markierungen etwa als lokale Materialanhäufungen ausgebildet sein. Es kann aber auch zur Bildung der Markierung ein Metallstreifen vorgesehen sein.

Die Entkoppelung wird weiter verbessert, wenn in besonderer Ausgestaltung der Erfindung, die beiden jeweils einer geradlinigen Markierung zugeordneten Detektoren auf verschiedenen Seiten der jeweiligen Markierung außerhalb des Einflußbereiches von Teilchen, die von anderen Markierungen ausgehen, liegen, sodaß sichergestellt ist, daß nur Teilchen der einem Detektorpaar jeweils zugeordneten Markierung auf dem Substrat von diesem Detektorpaar erfaßt werden.

Die vorstehend beschriebene erfindungsgemäße Anordnung ermöglicht, das Alignment sehr rasch auszuführen. Dabei kann die gesamte Struktur der Maske, eingeschlossen die auf der Maske befindlichen Markierungen, gleichzeitig auf das Substrat übertragen werden und das Alignment simultan mit der Übertragung erfolgen.

Um jedoch auch verhindern zu können, daß während des Alignments der Bilder der Markierungen der Maske auf die gewünschten Markierungen auf dem Substrat bereits das gesamte Maskenbild mit voller Intensität auf das Substrat auftrifft, was zu einer geringfügigen Versetzung der Abbildung gegenüber der gewünschten Sollage während der kurzen Zeit des Alignments führen würde, kann zur Ausschaltung dieses - wenn auch im Regelfall unbedeutenden - Fehlers, in weiterer Ausgestaltung der erfindungsgemäßen Anordnung ein Shutter vorgesehen sein, der in den Strahlengang einbring-, z.B. einschieb- oder einschwenkbar ist, wobei der Shutter eine Öffnung aufweist, durch die die gesamten, die Maske durchsetzenden Strahlen hindurchtreten und wobei im Abstand von dieser Öffnung im Shutter längliche Durchtrittsschlitze ausschließlich für die Strahlen, welche die Markierungen auf der Maske durchsetzen, angeordnet sind, so daß in einer Stellung des Shutters nur die Markierungen der Maske auf das Substrat abgebildet werden, in der anderen Stellung hingegen durch die Öffnung des Shutters hindurch, die gesamten Strukturen der Maske auf das Substrat übertragen werden.

Die Erfindung wird nachstehend anhand der Zeichnungen beispielsweise näher erläutert. Es zeigen,
Fig. 1 in einer schaubildlichen Darstellung eine Ionenprojektionseinrichtung, auf der das erfindungsgemäße Verfahren ausgeübt werden kann,
Fig. 2 schematisch eine Meßanordnung zur Aufnahme der Sekundärstrahlung eines auf eine Markierung des Substrates gerichteten Strahlenbündels,
Fig. 3 ein Schaubild, das die Abhängigkeit der von den Detektoren, die einer Markierung zugeordnet sind, erfaßten Spannungen zeigt,
Fig. 4 ein Diagramm, welches die Spannungsdifferenzen zeigt, die
Fig. 5 bis 8 in übertrieben vergrößerter Darstellung verschiedene Lagen zwischen der Markierung auf dem Substrat und der Projektion der Markierungen der Maske,
Fig. 9 ein Blockschaltbild, aus dem die Steuerung der Einrichtungen zur Justierung des Strahles ersichtlich ist,
Fig. 10 ein Beispiel für die Ansteuerung der Pole eines Multipoles,
Fig. 11 in den Strahlengang einschiebbare Shutter,
Fig. 12 eine Anordnung der Detektoren über einem Substrat, wie ein solches in Fig. 1 zu sehen ist, in schaubildlicher Darstellung und
Fig. 13 eine gegenüber den Fig. 5 - 8 sowie 12 abgeänderte Anordnung der Markierungen auf den jeweiligen Chips eines Substrates.

In der Zeichnung ist mit 1 eine Maske bezeichnet, die mit Markierungen 11 bis 13 versehen ist. Diese Markierungen werden durch einen Ionenstrahl, der aus einer Ionenquelle 22 kommt, auf ein Substrat 2 abgebildet, das mit Markierungen 16 bis 18 (Fig. 5 - 8, 12) versehen ist. Das Substrat 2 kann auf einem Tisch T befestigt werden, der mittels Motoren M₁ und M₂ in X- und Y-Richtung bewegt werden kann. Die Grobeinstellung des tisches T erfolgt über ein Steuersystem S, das jeweils die Motoren M₁ und M₂ ansteuert. Das Steuersystem S erhält Impulse von einem Detektor D in üblicher Weise. Aufgabe ist dabei eine Grobeinstellung des Substrates 2 bezüglich der Maske 1 vor der Belichtung, während die Feineinstellung des bildes der Maskenstruktur auf das Substrat, nachfolgend auf die Grobeinstellung erfolgt.

Durch Beeinflussung des Ionenstrahles werden die Markierungen 11 bis 13 der Maske 1 in Koinzidenz mit den auf dem Substrat vorhandenen, jeweils korrespondierenden Markierungen 16 bis 18 gebracht. Die Ionenprojektionseinrichtung weist im Strahlengang zwischen Maske 1 und dem Substrat 2 einen elektrostatischen Multipol 3 auf. Dieser Multipol ist im dargestellten Ausführungsbeispiel als Oktopol wiedergegeben. Weiters befindet sich im Strahlengang eine Einrichtung 4 zur Erzeugung eines magnetischen Drehfeldes um die optische Achse 5 und weiters eine Projektionslinse 6, die hinsichtlich der angelegten Spannung steuerbar ist, sodaß der Abbildungsmaßstab durch Ändern der an die Projektionslinse 6 angelegten Spannung geändert werden kann. Zwischen der Maske 1 und dem Multipol 3 befindet sich weiters eine Immersionslinse 23.

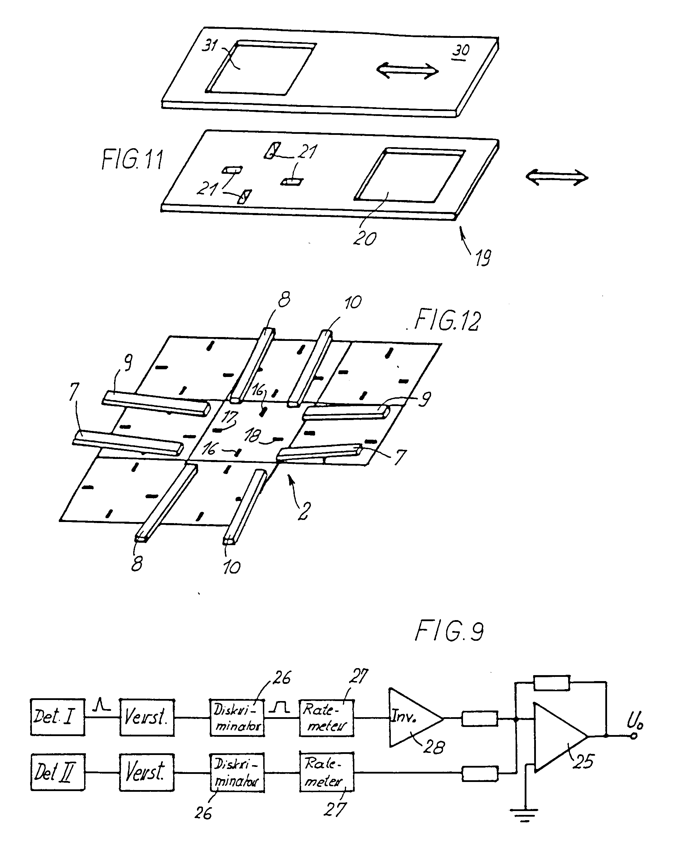

Die Projektionseinrichtung weist, wie dies in Fig. 12 mehr im Detail dargestellt ist, Detektoren 7 bis 10 auf. Diese Detektoren liefern bei Projektion der Markierungen 11 - 13 der Maske 1 auf das Substrat eine Spannung, die der von den Markierungen 16 bis 18 des Substrates 2 ausgehenden Sekundärstrahlung entspricht. Die Detektoren sind dabei in einer durch zwei teilbaren Anzahl vorgesehen. Im dargestellten Ausführungsbeispiel sind insgesamt acht Detektoren für die Sekundärstrahlung vorgesehen, zwei Paare 7, 8 dienen zur Steuerung des Multipoles 3, ein Paar 9 kann die Einrichtung 4 zur Erzeugung des magnetischen Drehfeldes Steuern, vorzuziehen ist es jedoch, wenn das Paar 9 im Verein mit einem Paar 8 von den für die Steuerung des Multipoles 3 vorgesehenen Paaren 7, 8 die Einrichtung 4 für die Erzeugung des magnetischen Drehfeldes steuert. Das Detektorenpaar 10 steuert die der Projektionslinse 6 zugeführte Spannung, sodaß je nach Änderung dieser Spannung eine Vergrößerung oder Verkleinerung der Abbildung der Strukturen von der Maske 1 auf das Substrat 2 erfolgen kann.

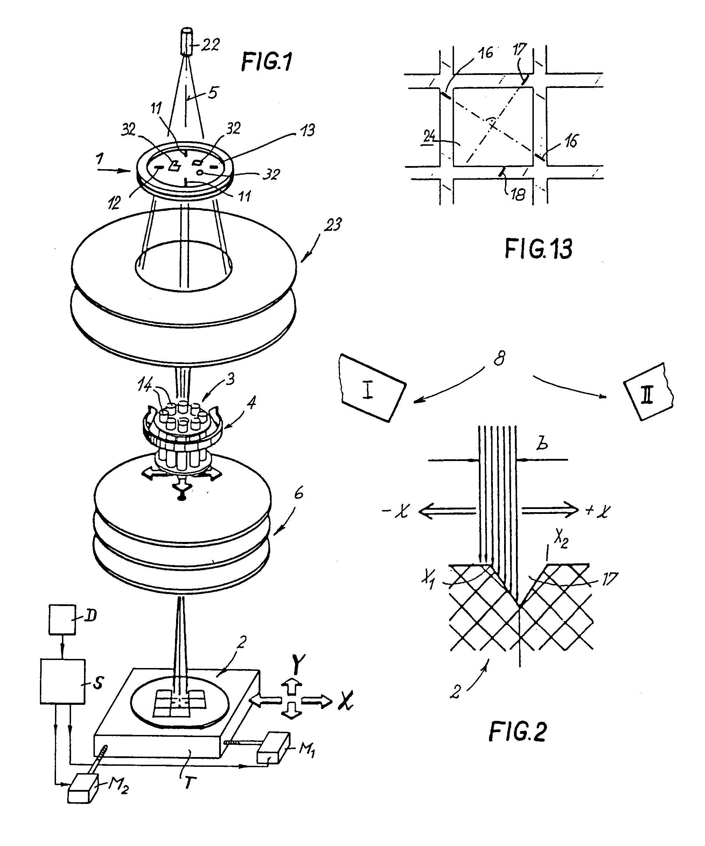

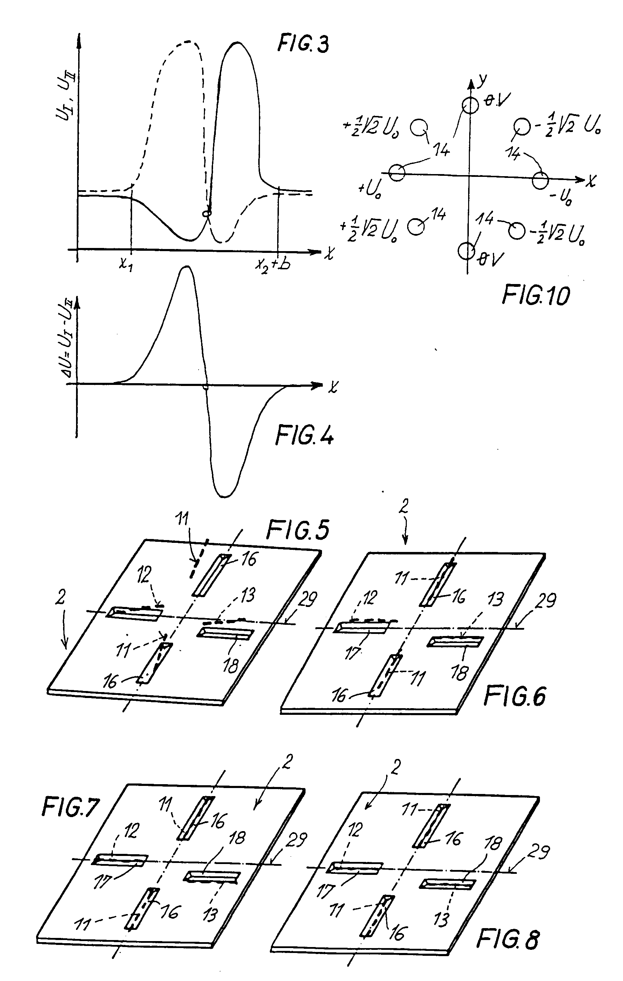

Durch entsprechende Steuerung des Multipoles 3 ist es möglich, den Strahl in X- bzw. Y-Richtung abzulenken (Fig. 1). Die Detektoren sind handelsübliche Ionenvervielfacherkanäle, welche abhängig von den erfaßten Ionen mittels der nachgeschalteten Elektronik (Fig. 9) die Steuerspannung Uₒ erzeugen. Jedem Detektorpaar 7 bis 10 ist eine geradlinige Markierung 16 bis 18 auf dem Substrat 2 zugeordnet. Die Zuordnung ist dabei so getroffen, daß zwei geradlinige Markierungen 16 miteinander fluchtend auf dem Substrat 2 angeordnet sind, eine dritte geradlinige Markierung 17 ist unter rechtem Winkel zu den beiden miteinander fluchtenden Markierungen 16 angeordnet, und schließlich ist eine vierte geradlinige Markierung 18 parallel zur dritten Markierung 17, jedoch seitlich zu dieser versetzt, auf dem Substrat 2 angeordnet. Die Markierung 17 liegt in der Symmetrielinie 29 zwischen den miteinander fluchtenden Markierungen 16, so daß bei Nichtübereinstimmung der außerhalb der Symmetrielinie 29 liegenden Markierung 18 mit dem zugeordneten Bild der Markierung 13 der Maske 1 durch bloße Maßstabsänderung der Abbildung die Übereinstimmung erzielt werden kann (Fig. 7, 8).

Die Anordnungen der Markierungen 16 - 18 auf dem Substrat 2 lassen besonders deutlich die Fig. 5 bis 8 bzw. 12 erkennen. Die geradlinigen Markierungen 16 - 18 auf dem Substrat 2 sind im dargestellten Ausführrungsbeispiel als Nut mit V-Querschnitt ausgebildet. Ganz allgemein können jedoch die geradlinigen Markierungen 16 - 18 auf dem Substrat 2 von Zonen gebildet werden, deren Emissionsvermögen für Sekundärstrahlung unterschiedlich von jenem des Substrates 2 ist. So können etwa die geradlinigen Markierungen auch von lokalen Materialanhäufungen gebildet werden. Es kann zur Bildung der Markierung jeweils auch ein Metallstreifen Verwendung finden.

Aus Fig. 2 im Verein mit den Fig. 3 und 4 sind die Vorgänge ersichtlich, die auftreten, wenn ein Strahl über eine als V-förmige Nut ausgebildete Markierung 16 in Richtung X geführt wird. Die Breite b des Strahles kann dabei etwa 1 um betragen. Die Bewegung des Strahles in X-Richtung sei als durch elektrostatische Beeinflussung des Strahles verursacht angesehen. Mit I und II sind dabei in Fig. 2 die Detektoren des Detektorenpaares 8 bezeichnet. An der Stelle X₁ beginnt bei einer Verschiebung des Strahles in positiver X-Richtung die Wirkung der Markierung 17 und endet an der Stelle X₂+b.

Die im Zuge der Verschiebung des Ionenstrahles von den Detektoren I und II erzeugten Spannungen, die ein Maß für die von den Detektoren aufgenommene Strahlung sind, sind in Fig. 3 ersichtlich, u.zw. ist dabei der Spannungsverlauf für den Detektor II in einem unterbrochenen Linienzug eingetragen, und der Spannungsverlauf für den Detektor I in einem durchgehenden Linienzug.

Die Differenz ΔU der Spannungen U_{I} und U_{II} ist aus Fig. 4 ersichtlich.

Aus Fig. 9 ist ersichtlich, wie die von den beiden Detektoren, die einer Markierung, z.B. der Markierung 16 in Fig. 12, zugeordnet sind, gebildeten Spannungssignale in die Steuerspannung Uₒ, z.B. für eine Ablenkung in X-Richtung, umgewandelt werden. Die von den Detektoren abgegebenen Impulse werden verstärkt, durch die Diskriminatoren 26 in Rechtecksimpulse verwandelt, sodann im Ratemeter 27 (z.B. ein Integrator) zu einer zur Impulsrate proportionalen Spannung integriert. Der Inverter 28 kehrt die auf diese Weise entstehende Spannung, die von dem einen Detektor (Detektor I) herrührt, in ihren Negativwert um, sodaß der Operationsverstärker 25 mit der Differenz der von den beiden Detektoren I, II gelieferten Spannungen angesteuert wird. Die vom Operationsverstärker 25 gelieferte Spannung Uₒ wird, entsprechend den Markierungen, von denen das Signal ausgeht, zur Steuerung des Multipols 3, zur Erzeugung des magnetischen Drehfeldes oder zur Steuerung der Projektionslinse 6 verwendet.

Fig. 10 zeigt als Beispiel, wie die Spannung Uₒ an einen Oktopol angelegt wird, damit dieser eine Ablenkung in X-Richtung hervorruft. Da im allgemeinen gleichzeitig auch in Y-Richtung abgelenkt werden soll, nämlich immer dann, wenn gleichzeitig die der entsprechenden Markierung (17 in Fig. 12 und Fig. 5 - 8) zugeordneten Detektoren ein Signal U_{y} liefern, müssen die beiden Spannungen Uₒ und U_{y} noch über eine geeignete Schaltung vektoriell addiert werden. Die entstehenden Summenspannungen werden den entsprechenden Polen des Oktopols zugeführt.

Analog zu Fig. 10 wird die vom Operationsverstärker 25 gelieferte Spannung Uₒ zur Erzeugung eines Stromes in der Spule 4, welche die Rotation des Projektionsbildes bewirkt, und zur Steuerung der Projektionslinse 6, mit der die Maßstabskorrektur vorgenommen wird, verwendet.

Aus den Fig. 5 bis 8 ist dabei ersichtlich, in welcher Weise die Einrichtung der Projektionen der auf der Maske 1 vorgesehenen Markierungen 11 bis 13 auf die Markierungen 16 bis 18 des Substrates 2 erfolgt u.zw. sind dabei jeweils die Projektionen der Markierungen auf der Maske 1 mit unterbrochenen Linien dargestellt und so bezeichnet, wie die zugehörigen Schlitze auf der Maske 1, wobei die Schlitze der Maske 1 nicht unbedingt als jeweils ein einziger Schlitz ausgebildet sein müssen, sondern ein Schlitz auch durch mehrere, miteinander fluchtende Durchbrechungen der Maske 1 ausgebildet sein kann, sodaß dann eine Abbildung entsteht, wie sie in den Fig. 5 bis 8 mit 11 bis 13 bezeichnet ist.

Die Fig. 5 veranschaulicht dabei die gegenseitige Lage der Markierungen 16 bis 18 auf dem Substrat und der Abbildungen 11 bis 13 der Markierungen auf der Maske 1, nachdem eine Justierung in X-Richtung erfolgt ist.

Fig. 6 gibt dann die Lage wieder, wie sie sich einstellt nach einer Drehung des projizierten Bildes der Maskenstruktur. Es ist dabei ersichtlich, daß die Bilder der Markierungen 11 der Maske 1 mit dem Scheitel der V-förmigen Markierungen 16 zusammenfallen. Erfolgt nunmehr eine Verschiebung des projizierten Bildes der Maskenstruktur in Y-Richtung, so ist ersichtlich, daß von dieser Verschiebung die den Markierungen 16 des Substrates zugeordneten Detektoren unbeeinflußt bleiben, d.h. die Bewegungen des Bildes in den einzelnen Richtungen sind voneinander entkoppelt.

Fig. 7 zeigt dann die Lage nach der in Y-Richtung erfolgten Justierung. Die Abbildung der Markierung 12 des Substrates 2 kommt dabei in den Scheitel der V-förmigen Nut 17 des Substrates 2 zu liegen. Die einzige Markierung, die im allgemeinen nicht mit dem entsprechenden Bild einer Markierung der Maske 1 zusammenfällt, ist dabei die Markierung 18, die parallel zur Markierung 17, jedoch gegenüber dieser seitlich aus der Symmetrielinie 29 verschoben, angeordnet ist.

Um nun auch die Abbildung der Markierung 13 des Substrates 1 in den Scheitel der Markierung 18 auf dem Substrat 2 zu bringen, ist eine Maßstabsänderung erforderlich, die durch Verändern der Spannung, die an der Projektionslinse 6 anliegt, erfolgt.

Die Stellung nach erfolgter Maßstabsänderung ist aus Fig. 8 ersichtlich. Diese Fig. 8 läßt erkennen, daß nachdem zuvor bereits eine Justierung in X- und Y-Richtung sowie eine Drehung und Maßstabsänderung stattgefunden hat, nunmehr die Abbildung der Markierungen 11 bis 13 der Maske 1 auf dem Substrat 2 mit den dort befindlichen geradlinigen Markierungen 16 bis 18 zusammenfällt, d.h. das projizierte Ionenbild der Maske 1 ist richtig auf das Substrat 2 ausgerichtet. Die vorstehend aus Gründen der Deutlichkeit als aufeinanderfolgend beschriebenen Justierschritte erfolgen erfindungsgemäß jedoch gleichzeitig, da es sich um entkoppelte Regelkreise handelt.

Die beiden jeweils einer geradlinigen Markierung 16 bis 18 zugeordneten Detektoren 7 bis 10 liegen auf verschiedenen Seiten der jeweiligen Markierung, wobei sichergestellt ist, daß nur Teilchen der zugeordneten Markierung erfaßt werden. Während der mechanischen Tischbewegung, um von der Belichtung eines Chips auf die Belichtung des Nachbarchips überzugehen, gelangt kein Ionenstrahl auf das Substrat, da dies durch einen Primärshutter 30 verhindert ist, der eine Öffnung 31 und einen vollen Abschnitt besitzt (Fig. 11). Anstelle eines mechanischen Primärshutters 30 kann auch eine elektronische Ablenkung des gesamten Ionenbildes erfolgen, z.B. auf ein Prallblech, das abseits vom Wafer angeordnet ist. Da erfindungsgemäß die Justierung des Maskenbildes auf dem Substrat 2 durch Ablenkung des Projektionsbildes erfolgt und diese Ablenkung äußerst schnell (z.B. in einigen Millisekunden bei einer Gesamtbelichtungszeit von 1 sec) erfolgen kann, ist es möglich, die Maske 1 mit ihrer gesamten Struktur, d.h. sowohl die Markierungen 11 - 13 als auch die auf das Substrat zu übertragende Arbeitsstruktur 32 gleichzeitig zu übertragen, ohne daß in der Zeit zwischen dem Beginn der Belichtung des Chips (und damit des Beginnes des Alignmentvorganges) und dem Erreichen der erforderlichen Ausrichtung ein merkbarer Fehler in der Belichtung auftritt. Somit ist auch während des Alignments eine Belichtung des Substrates mit voller Intensität möglich. Soll jedoch auch dies ausgeschaltet werden, so sind Vorkehrungen zu treffen, die gewährleisten, daß die Arbeitsstrukturen 32 erst dann von der Maske 1 durch die Strahlen auf das Substrat 2 übertragen werden, wenn die Ausrichtung beendet ist. Zu diesem Zweck kann beispielsweise ein zusätzlicher Shutter 19 (Fig. 12) vorgesehen werden, der in den Strahlengang der Projektionseinrichtung eingeschwenkt werden kann. Der Shutter 19 besitzt eine Öffnung 20, durch welche die gesamte, die Maske 1 durchsetzende Strahlung hindurchtreten kann. Durch diese Öffnung erfolgt daher die Übertragung der Arbeitsstrukturen 32 der Maske 1 auf das Substrat 2. Im Abstand von der Öffnung 20 befinden sich längliche Durchtrittsschlitze 21, durch welche nur jene Strahlen hindurchtreten können, welche die Markierungen 11 bis 13 auf der Maske 1 durchsetzen. Befinden sich daher nur die Öffnungen 21 des Shutters 19 im Strahlengang der Projektionseinrichtung, so werden nur die Markierungen 11 bis 13 der Maske 1 auf das Substrat 2 übertragen, sodaß die Ausrichtung (das Alignment) erfolgen kann, ohne daß bereits die Arbeitsstruktur 32 auf das Substrat projiziert wird.

Sobald das Alignment beendet ist, d.h. eine Stellung, die der Fig. 8 der Zeichnung entspricht, erreicht ist, wird durch eine "Hold"- Schaltung der Strom und die Spannung festgehalten, wodurch die erreichte Lage stabilisiert wird, sodann wird der Shutter 19 verschoben, sodaß nunmehr die Öffnung 20 im Strahlengang liegt und demgemäß die gesamte Struktur der Maske 1, also auch die Arbeitsstruktur 32, auf das Substrat 2 abgebildet werden kann.

Fig. 13 zeigt eine Möglichkeit, wie die Markierungen 16 - 18 um einen Chipbereich 24 so angeordnet werden können, daß jede Markierung genau einem Chip zugeordnet ist.

## Patentansprüche

1. Anordnung zum Positionieren der Abbildung der Struktur einer Maske (1) auf ein Substrat (2), für die Ionenprojektionslithographie, bei dem die Maske (1) und das Substrat an miteinander korrespondierenden Stellen mit Markierungen (11 bis 13 bzw. 16 bis 18) versehen, die Markierungen (11 - 13) der Maske (1) auf das Substrat (2) abgebildet und durch Beeinflussung des Strahles, die Abbildungen der Markierungen (11 - 13) der Maske (1) auf dem Substrat (2) in Koinzidenz mit den auf dem Substrat (2) vorhandenen, jeweils korrespondierenden Markierungen (16 bis 18) gebracht werden, mittels einer Ionenprojektionseinrichtung, bei der im Strahlengang zwischen Maske (1) und dem Substrat (2) ein elektrostatischer Multipol (3), insbes. Oktopol, eine Einrichtung (4) zur Erzeugung eines magnetischen Drehfeldes um die optische Achse und eine hinsichtlich der angelegten Spannung steuerbare Projektionslinse (6) zur Änderung des Abbildungsmaßstabes angeordnet sind, wobei die Projektionseinrichtung mit Detektoren (7 - 10) für die von den Markierungen (11 bis 13) auf dem Substrat (2) ausgehende Sekundärstrahlung in einer durch zwei teilbaren Anzahl versehen ist und die Markierungen (16 - 18) auf dem Substrat von Zonen, z.B. Nuten mit V-Querschnitt, gebildet sind, deren Emissionsvermögen für Sekundärstrahlung unterschiedlich von jenem des Substrates (2) ist und von den Detektorpaaren (7 bis 10) jeweils zwei Paare (7, 8) zur Steuerung des Multipoles (3), ein Paar (9) zur Steuerung der Einrichtung (4) zur Erzeugung eines magnetischen Drehfeldes und ein weiteres Paar (10) zur Steuerung der Projektionslinse (6) entweder im Sinne einer Vergrößerung oder Verkleinerung der Abbildung vorgesehen sind, dadurch gekennzeichnet, daß die jedem Detektorpaar (7 bis 10) auf dem Substrat zugeordnete Markierung (16 - 18) geradlinig ausgebildet ist, wobei zwei Markierungen (16) miteinander fluchtend auf dem Substrat (2) angeordnet sind, eine dritte Markierung (17) unter einem Winkel, bevorzugt unter einem rechten Winkel, zu den beiden miteinander fluchtenden Markierungen (16) angeordnet ist und eine vierte Markierung (18) parallel zur dritten (17), jedoch seitlich zu dieser versetzt auf dem Substrat (2) angeordnet ist.

2. Anordnung nach Anspruch 1, dadurch gekennzeichnet, daß in der Symmetrielinie zwischen den beiden fluchtend zueinander angeordneten Markierungen (16) die unter einem Winkel zu diesen Markierungen (16) liegende dritte Markierung (17) angeordnet ist.

3. Anordnung nach Anspruch 1 oder 2, dadurch gekennzeichnet, daß die geradlinigen Markierungen als lokale Materialanhäufung ausgebildet sind oder daß ein Metallstreifen zur Bildung der Markierungen vorgesehen ist.

4. Anordnung nach einem der Ansprüche 1 bis 3, dadurch gekennzeichnet, daß die beiden jeweils einer geradlinigen Markierung (16 - 18) zugeordneten Detektoren (7 - 10) auf verschiedenen Seiten der jeweiligen Markierung außerhalb des Einflußbereiches von Teilchen, die von anderen Markierungen ausgehen, liegen, so daß sichergestellt ist, daß nur Teilchen der einem Detektorpaar jeweils zugeordneten Markierung auf dem Substrat (2) von diesem Detektorpaar erfaßt werden.

5. Anordnung nach einem der Ansprüche 1 bis 4, dadurch gekennzeichnet, daß ein Shutter (19) vorgesehen ist, der in den Strahlengang einbringbar, z.B. einschieb- oder einschwenkbar ist, wobei der Shutter (19) eine Öffnung (20) aufweist, durch die die gesamte, die Maske (1) durchsetzenden Strahlen hindurchtreten und daß im Abstand von dieser Öffnung (20) im Shutter längliche Durchtrittsschlitze (21) ausschließlich für die Strahlen, welche die Markierungen (11 - 13) auf der Maske (1) durchsetzen, angeordnet sind, so daß in einer Stellung des Shutters (19) nur die Markierungen (11 - 13) der Maske (1) auf das Substrat (2) abgebildet werden, in der anderen Stellung hingegen durch die Öffnung (20) des Shutters (19) hindurch, die gesamten Strukturen der Maske (1) auf das Substrat (2) übertragen werden.

## Claims

1. Arrangement for positioning the image of the structure of a mask (1) on a substrate (2) for ion projection lithography in which the mask (1) and the substrate are provided at corresponding positions with markings (11 to 13 and 16 to 18, respectively), the markings (11-13) on the mask (1) are imaged onto the substrate (2) and by controlling the beam the images of the markings (11-13) on the mask (1) are brought into coincidence on the substrate (2) with the respective corresponding markings (16 to 18) present on the substrate (2) by means of an ion projection device in which, disposed in the beam path between the mask (1) and the substrate (2), there is an electrostatic multipole (3), particularly an octupole, a device (4) for producing a magnetic rotating field about the optical axis and a projection lens (6), which may be controlled with regard to the applied voltage, for altering the imaging scale, whereby the projection device is provided with an even number of detectors (7-10) for the secondary radiation emanating from the markings (11 to 13) on the substrate (2) and the markings (16-18) on the substrate are formed by zones, e.g. grooves of V-cross-section, whose emissivity for secondary radiation is different from that of the substrate (2) and, of the detector pairs (7 to 10), two pairs (7,8) are provided for controlling the multipole (3), one pair (9) is provided for controlling the device (4) for producing a magnetic rotating field and a further pair (10) is provided for controlling the projection lens (6) either to enlarge or to reduce the image, characterised in that the marking (16-18) associated with each pair of detectors (7 to 10) on the substrate is of straight line construction, whereby two markings (16) are arranged in alignment with one another on the substrate (2), a third marking (17) is arranged at an angle, preferably at right-angles, to the two aligned markings (16) and a fourth marking (18) is arranged parallel to the third (17) but laterally offset from it on the substrate (2).

2. Arrangement as claimed in Claim 1, characterised in that the third marking (17) extending at an angle to the two markings (16) arranged in alignment with one another is arranged in the line of symmetry between these markings (16).

3. Arrangement as claimed in Claim 1 or 2, characterised in that the straight line markings are constructed as a localised accumulation of material or that a metal strip is provided to form the markings.

4. Arrangement as claimed in one of Claims 1 to 3, characterised in that the two detectors (7-10) associated with a respective straight line marking (16-18) lie on different sides of the respective marking outside the range of influence of particles which emanate from other markings so that it is ensured that only particles from the marking on the substrate (2) associated with one detector pair are detected by this detector pair.

5. Arrangement as claimed in one of Claims 1 to 4, characterised in that a shutter (19) is provided which may be moved, e.g. slid or pivoted, into the beam path, whereby the shutter (19) has an opening (20) through which all the beams passing through the mask (1) pass and that arranged spaced from this opening (20) in the shutter there are elongate slits (21) exclusively for the beams which pass through the markings (11-13) on the mask (1) so that in one position of the shutter (19) only the markings (11-13) on the mask (1) are imaged on the substrate (2) whereas in the other position the entire structures of the mask (1) are transferred through the opening (20) of the shutter (19) onto the substrate (2).

## Revendications

1. Dispositif de positionnement de la reproduction de la structure d'un masque (1) sur un substrat (2), pour la lithographie par projection d'ions, dans lequel le masque (1) et le substrat sont pourvus de marquages (respectivement 11 à 13 et 16 à 18) en des points correspondant les uns aux autres, les marquages (11 à 13) du masque (1) sont reproduits sur la substrat (2) et, par influence du faisceau, les reproductions des marquages (11 à 13) du masque (1) sur le substrat (2) sont amenées en coïncidence avec les marquages (16 à 18) correspondants, existant sur le substrat (2), au moyen d'un dispositif de projection d'ions, dans lequel sont montés, dans le parcours du faisceau entre le masque (1) et le substrat (2), un multipôle électrostatique (3), en particulier un octopôle, un dispositif (4) destiné a produire un champ tournant magnétique autour de l'axe optique ainsi qu'une lentille de projection (6), commandable en ce qui concerne la tension appliquée, destinée à modifier l'échelle de reproduction, dans lequel le dispositif de projection est doté d'un nombre, divisible par deux, de détecteurs (7 à 10) pour le rayonnement secondaire partant des marquages (11 à 13) du substrat (2) et les marquages (16 à 18) sont formés sur le substrat par des zones, par exemple des rainures de section transversale en V, dont le pouvoir d'émission du rayonnement secondaire est différent de celui du substrat (2) et dans lequel parmi les paires de détecteurs (7 à 10), deux paires (7, 8) sont prévues pour commander le multipôle (3), une paire (9) pour commander le dispositif (4) destiné à produire un champ tournant magnétique et une autre paire (10) pour commander la lentille de projection (6), dans le sens d'un agrandissement ou d'une réduction de la reproduction, caractérisé en ce que le marquage (16 à 18), associé à chaque paire de détecteurs (7 à 10) sur le substrat, est rectiligne, deux marquages (16) étant alignés entre eux sur le substrat (2), un troisième marquage (17) formant un angle, de préférence un angle droit, avec les deux marquages (16) alignés entre eux et un quatrième marquage (18) étant parallèle au troisième marquage (17), mais décalé latéralement par rapport à celui-ci, sur le substrat (2).

2. Dispositif selon la revendication 1, caractérisé en ce que le troisième marquage (17) qui forme un angle par rapport aux marquages (16) alignés entre eux, est situé sur l'axe de symétrie, entre ces marquages (16).

3. Dispositif selon la revendication 1 ou 2, caractérisé en ce que les marquages rectilignes sont realisés sous la forme d'une accumulation locale de matière ou en ce qu'il est prévu une bande de métal pour former les marquages.

4. Dispositif selon l'une des revendications 1 à 3, caractérisé en ce que les deux détecteurs (7 à 10), associés à un marquage rectiligne (16 à 18), se situent sur des côtés différents du marquage respectif, à l'extérieur de la zone d'influence de particules provenant d'autres marquages, ce qui garantit que seules des particules du marquage du substrat (2), associé à une paire de détecteurs, sont détectées par cette paire de détecteurs.

5. Dispositif selon l'une des revendications 1 à 4, caractérisé en ce qu'il est prévu un obturateur (19), à placer dans le faisceau, par exemple par introduction ou pivotement, l'obturateur (19) présentant une ouverture (20) par laquelle passe la totalité des rayons traversant le masque (1) et en ce qu'à une certaine distance de cette ouverture (20), pratiquée dans l'obturateur, il est prévu des fentes de passage (21) allongées, exclusivement pour les rayons qui traversent les marquages (11 à 13) du masque (1), ce qui fait que dans une position de l'obturateur (19), seuls les marquages (11 à 13) du masque (1) sont reproduits sur le substrat (2), tandis que dans l'autre position la totalité des structures du masque (1) est transférée sur le substrat (2), à travers l'ouverture (20) de l'obturateur (19).
